# EUROPÄISCHE PATENTSCHRIFT

(11) **EP 2 849 299 B1**
(45) Veröffentlichungstag und Bekanntmachung des Hinweises auf die Patenterteilung: **04.04.2018**
(21) Anmeldenummer: 14155311.5
(22) Anmeldetag: 17.02.2014
(51) Int. Cl.: H02G 3/32, H02G 3/06

(54) **Vorrichtung zur Fixierung eines Kabels und Funktionseinheit**
Device for fixing a cable and a functional unit
Dispositif de fixation d'un câble et d'unité fonctionnelle

(30) Priorität: 11.09.2013 EP 13183877
(43) Veröffentlichungstag der Anmeldung: 18.03.2015
(73) Patentinhaber: Lapp Engineering & Co., 6330 Cham (CH)
(72) Erfinder: Schädle, Christian, DE-70186 Stuttgart (DE)
(74) Vertreter: Rutz & Partner

(56) Entgegenhaltungen:
- DE-T2- 69 804 396
- GB-A- 266 109
- GB-A- 1 178 579
- US-A1- 2003 139 087
- US-A1- 2007 087 628

## Beschreibung

Die Erfindung betrifft eine Vorrichtung zur Fixierung eines Kabels insbesondere im Bereich einer Kabeldurchführung, wie im Eingangsbereich eines elektrischen Geräts oder eines Steckverbinders, sowie eine elektrische Funktionseinheit mit einer solchen Fixiervorrichtung.

Vorrichtungen zur Fixierung von Kabeln werden üblicherweise in Bereichen eingesetzt, in denen ein Kabel in ein Gerät oder in einen Steckverbinder überführt wird. Oft werden Klemmen und Bügel, beispielsweise unter Verwendung von Schrauben derart miteinander verbunden, dass das Kabel im Bereich der Klemmen durch partielle Kompression mechanisch fixiert wird. Diese Art der Fixierung ist mechanisch sehr stabil, so dass sich das Kabel auch unter grösserer Krafteinwirkung nicht vom Gerät oder Steckverbinder lösen kann. Eine derartige Fixiervorrichtung, die im Eingangsbereich einer elektrischen Vorrichtung installiert wird, ist beispielsweise aus der EP2541706A2 bekannt.

Aus der DE69804396T2 ist ein Steckverbinder mit einer Anschlusshülse, mit einem inneren und einem äusseren rohrförmigen zylindrischen Teilbereich, bekannt. Die Abschirmung oder die Abschirmung und der Mantel können in den Hohlraum zwischen dem inneren und dem äusseren Teilbereich der Anschlusshülse eingeführt werden. Mit einem Crimpring wird die Anschlusshülse mit den übrigen Komponenten des Steckverbinders elektrisch leitend verbunden und mechanisch fixiert.

Aus der US2007/087628A1 ist ein Steckverbinder für Koaxialkabel mit geringem Durchmesser bekannt. Das Ende eines Koaxialkabels wird in den Steckverbinder geschoben, wobei der Mantel und die Abschirmung durch in einer Öffnung angeordnete Vorsprünge gehalten werden.

Aus der GB1178579A ist eine dichte Durchführung für armierte Kabel bekannt. Eine konische Hülse wird unter die Armierung des Kabels eingeführt und durch eine über eine Druckschraube beaufschlagte Gegenhülse mit der Armierung verpresst.

Aus der US2003/139087A1 ist eine Vorrichtung zur Zugentlastung für Kabelverbindungen bekannt. Ein konisches Element mit einer Bohrung für das Kabelinnere und einer gezahnten oder gestuften Aussenfläche wird unter den Kabelmantel geschoben. Eine Aussenhülse mit korrespondierenden Formelementen auf der Innenfläche wird axial über das konische Element geschoben und der Kabelmantel dadurch fixiert.

Aus der GB266109A ist eine Kabeldurchführung für armierte Kabel bekannt. Eine Innenhülse wird unter die Armierung geschoben und durch eine Klemmvorrichtung mechanisch beaufschlagt, wodurch die Armierung mechanisch fixiert wird.

Bei den genannten Fixiervorrichtungen entstehen hingegen oft unerwünschte Deformationen der installierten Kabel, wodurch deren Eigenschaften beeinträchtigt werden und gegebenenfalls auch Schäden resultieren können. Während des Einsatzes der installierten Kabel werden diese wohl sicher gehalten, aber auch starken Beanspruchungen unterworfen, die zu einer weiteren Beeinträchtigung der Kabeleigenschaften bis hin zu einer Schädigung des Kabels führen kann. Bei regelmässiger Biegung oder Torsion des Kabels im Anschlussbereich können Schäden an den Isolationsschichten oder gar ein Bruch von Leitungsadern auftreten. Dies ist auf eine hohe punktuelle Belastung der Isolationsschichten und der Leitungsadern in dem Bereich zurückzuführen, in dem Elemente der Fixiervorrichtung auf das Kabel einwirken. Mechanische Belastungen des Kabels werden daher punktuell übertragen, wodurch hohe Belastungen an den Kabelelementen auftreten können. Diese Belastungen sind besonders in Einsatzbereichen problematisch, in denen elektrische Leitungen regelmässig Torsions- und/oder Biegebelastungen ausgesetzt sind. In solchen Einsatzbereichen wird die Lebensdauer der Kabel bei der Verwendung der bekannten Fixiervorrichtungen oft erheblich reduziert. Bei einer - beispielsweise durch eine Norm - vorgegebenen minimalen Anzahl zu überstehender Torsions- und/oder Biegebelastungen müssen daher stärker belastbare Kabel verwendet werden, die beispielsweise einen verstärkten Mantel aufweisen, was mit erheblichen Mehrkosten verbunden ist.

Der vorliegenden Erfindung liegt somit die Aufgabe zugrunde eine verbesserte Fixiervorrichtung für Kabel sowie eine elektrische Funktionseinheit zu schaffen, die mit einer solchen Fixiervorrichtung versehen ist.

Insbesondere ist eine Fixiervorrichtung zu schaffen, mittels der Kabel zum Beispiel in Steckverbindern oder in Eingangs- oder Ausgangsbereichen elektrischer Geräts stabil, schonend und auch unter Einwirkung von Zugkräften sicher gehalten werden können.

Mittels der Fixiervorrichtung gehaltene Kabel sollen zudem stärker belastbar sein und einer höheren Anzahl von Torsions- und/oder Biegebeanspruchungen unterworfen werden können, ohne dass die Kabeleigenschaften beeinträchtigt werden oder das Kabel beschädigt wird. Mittels der Fixiervorrichtung sollen daher auch weniger robuste Kabel sicher und schonend gehalten werden können.

Diese Aufgabe wird mit einer Fixiervorrichtung und einer Funktionseinheit gelöst, welche die in Anspruch 1 bzw. 12 angegebenen Merkmale aufweisen. Vorteilhafte Ausgestaltungen der Erfindung sind in weiteren Ansprüchen angegeben.

Die Vorrichtung dient der Fixierung eines elektrischen Kabels, welches eine oder mehrere Leitungsadern und gegebenenfalls eine metallene Abschirmung aufweist, die von einem Kabelmantel umschlossen sind. Insbesondere dient die Vorrichtung der Fixierung eines elektrischen Kabels in einem Steckverbinder oder im Eingangsbereich oder Ausgangsbereich eines elektrischen Geräts.

Die Fixiervorrichtung umfasst eine äussere Fixiereinheit, mittels der das Kabel zumindest teilweise umschliessbar und ein Anpressdruck auf den Kabelmantel ausübbar ist, mittels dessen das Kabel fixierbar ist.

Erfindungsgemäss weist die äussere Fixiereinheit eine Durchtrittsöffnung auf, die der Durchführung des Kabels und der Aufnahme einer Ring förmigen inneren Fixiereinheit dient, die derart ausgestaltet ist, dass sie zwischen dem Kabelmantel und den Leitungsadern einfügbar ist, so dass sie den von der äusseren Fixiereinheit auf den Kabelmantel ausgeübten Anpressdruck zumindest teilweise aufnehmen kann.

Mit der erfindungsgemässen Fixiereinheit wird eine mechanische Deformierung des Adernverbundes bei der Fixierung des Kabels verhindert. Die von der äusseren Fixiereinheit ausgeübten Kräfte werden nicht vom Adernverbund, sondern von der inneren Fixiereinheit ganz oder teilweise aufgefangen. Weiterhin werden punktuelle Belastungen der Leitungsadern vorteilhaft vermieden.

Die äussere Fixiereinheit ist derart ausgestaltet, dass sie den Kabelmantel ganz oder teilweise umschliessen kann und eine Öffnung zur Durchführung des Kabels mit der darauf angeordneten inneren Fixiereinheit aufweist. Der Innendurchmesser der äusseren Fixiereinheit - im geschlossenen Zustand -ist derart auf das Kabel und den Aussendurchmesser der inneren Fixiereinheit abgestimmt, dass der zwischen den beiden Einheiten angeordnete Kabelmantel mechanisch fixierbar ist.

Die Positionierung der inneren Fixiereinheit kann dadurch vereinfacht werden, dass beim Abisolieren des Kabelendes gleichzeitig auch der Kabelmantel ein Stück weit eingeschnitten wird, so dass er sich leicht von den Adern ablösen lässt und manuell oder maschinell aufgeweitet werden kann. Dies kann beispielsweise erzielt werden, indem ein übliches Abmantelungswerkzeug mit einer Klinge versehen wird.

Die äussere Fixiereinheit kann sowohl aus einem als auch aus mehreren Vorrichtungsteilen bestehen. Beispielsweise können zwei schalenförmige Vorrichtungsteile verwendet werden. Die beiden vorzugsweise identischen Vorrichtungsteile sind beispielsweise mit Hilfe von Schrauben, Gewindeelementen und/oder Scharnieren miteinander verbindbar.

Die äussere Fixiereinheit kann vorteilhaft in einen Steckverbinder, einen Stecker oder eine Kupplung, integriert werden. Beispielsweise umfasst ein Stecker im Eingangsbereich zwei parallel zueinander ausgerichtete und voneinander beabstandete Halbschalen auf, die mit einem Aussengewinde versehen sind. Indem eine mit einem Innengewinde versehene Überwurfmutter auf die beiden Halbschalen gedreht wird, werden die Halbschalen gegeneinander und somit gegen den Kabelmantel und die innere Fixiereinheit gedrückt. Die äussere Fixiereinheit kann auch ein mehrteiliger Lamellenkorb sein, welcher anhand einer Überwurfmutter komprimiert werden kann.

Entsprechende Steckverbinder sind dem Fachmann aus der Offenlegungsschrift EP 2 573 878 A1 bekannt. Anhand der erfindungsgemässen Fixiervorrichtung können somit äusserst stabile elektrische Verbindungen, insbesondere Steckverbindungen, realisiert werden, die höchsten Ansprüchen genügen.

Die zueinander korrespondierenden Vorrichtungsteile der äusseren Fixiereinheit weisen vorzugsweise formschlüssig ineinander greifende Vorrichtungselemente auf, welche eine gegenseitige Verschiebung der Vorrichtungsteile aufgrund von Torsion und/oder Biegung verhindern.

Die innere Fixiereinheit ist vorzugsweise als hohlzylindrische Ring ausgestaltet, die in sich geschlossen oder teilweise unterbrochen, gegebenenfalls mit einem Schlitz versehen ist. In der Ausgestaltung mit einem Schlitz liegen sich zwei Hülsenenden in einem Abstand von z.B. 1mm bis 5mm gegenüber. Beim Festziehen der Fixiervorrichtung wird die innere Fixiereinheit so weit elastisch deformiert, bis die beiden Hülsenenden aufeinander treffen und eine weitere Deformation unterbleibt und der gehaltene Adernverbund nicht beschädigt werden kann.

Die innere und auch die äussere Fixiereinheit sind vorzugsweise mit Formelementen versehen, die im verschlossenen Zustand Material des Kabelmantels verdrängen oder aufnehmen können. Formelemente können auf der Innenseite der äusseren Fixiereinheit und an der Innenseite und/oder Aussenseite der inneren Fixiereinheit vorgesehen werden. Im montierten Zustand können die Formelemente somit direkt auf den zwischen den beiden Fixiereinheiten liegenden Kabelmantel einwirken und die Fixierung desselben verbessern. Die Formelemente weisen beispielsweise die Form von Kanten, Rillen, Wellen, Rippen, Einfaltungen oder Zacken auf, wobei die Formelemente der inneren und äusseren Fixiereinheit vorzugsweise derart aufeinander abgestimmt sind, dass sie im montierten Zustand ineinander greifen. Die Höhe der Formelemente, beispielsweise die Zackenhöhe einer Sternform wird dabei derart gewählt, dass der Kabelmantel deformiert und formschlüssig gehalten wird, ohne dass Beschädigungen auftreten. In vorzugsweisen Ausgestaltungen sind die Innenseite und die Aussenseite der hülsenförmigen inneren Fixiereinheit unterschiedlich ausgestaltet. Beispielsweise weist die Innenseite eine weitgehend glatte Oberfläche auf, während die Aussenseite strukturiert ist.

Vorzugsweise weist die innere Fixiereinheit einen kreisförmigen Querschnitt auf. Alternativ können jedoch auch an andere Kabelformen angepasste Querschnitte vorgesehen werden. Für Flachbandkabel wird beispielsweise ein Querschnitt mit entsprechend grosser Breite und geringer Höhe vorgesehen.

In vorzugsweisen Ausgestaltungen ist die innere Fixiereinheit derart elastisch deformierbar, dass sie den bei der Montage der äusseren Fixiereinheit entstehenden Anpressdruck aufnehmen kann und nur in reduzierten Mass an den innen liegenden Adernverbund abgibt. Aufgrund ihrer Elastizität ist die innere Fixiereinheit in einem gewünschten Bereich an den Durchmesser des Adernverbundes anpassbar und übt gleichzeitig eine Gegenkraft auf den Kabelmantel und die äussere Fixiereinheit aus. Diese Ausführungsform hat somit den Vorteil, dass die Fixiervorrichtung für verschiedene Kabeldimensionen verwendbar ist. Es erfolgt somit eine Anpassung an den vorliegenden Adernverbund, ein stabiles Festklemmen des Kabelmantels, ein schonendes Halten des Adernverbunds und ein Stabilisieren der miteinander verbundenen Vorrichtungsteile, die sich aufgrund der Vorspannung der inneren Fixiereinheit auch beim Auftreten von Vibrationen nicht voneinander lösen.

Das gehaltene Kabel kann eine oder mehrere zusätzliche Schichten aufweisen, wobei die innere Fixiereinheit vorzugsweise unmittelbar unterhalb des Kabelmantels positioniert wird. Sofern eine metallene Abschirmung vorgesehen ist, wird die innere Fixiereinheit entweder oberhalb oder unterhalb der Abschirmung positioniert. Mittels einer metallenen inneren Fixiereinheit kann die Abschirmung vorteilhaft kontaktiert werden. Aufgrund der Elastizität der inneren Fixiereinheit, die die Abschirmung beispielsweise nach aussen gegen den Kabelmantel drückt oder die von aussen gegen die Abschirmung gedrückt wird, wird eine gute Kontaktierung gewährleistet. Vorzugsweise wird die innere Fixiereinheit mit einem Kontaktelement, einer Kontaktöse oder einem Kontaktflansch, versehen, der mit einem Anschlusskabel, beispielsweise einem Erdungskabel verbindbar ist.

Die erfindungsgemässe Kabelfixierung kann direkt in ein Gehäuse eines elektrischen Geräts oder eines Steckverbinders integriert oder mit diesem verbindbar sein. Vorzugsweise wird das Gehäuse eines Steckverbinders mit einer Aussparung versehen, welche derart ausgeführt ist, dass die äussere Fixiereinheit im geschlossenen Zustand passgenau umschlossen und gehalten wird. Die äussere Fixiereinheit kann auch vorteilhaft mit dem Gehäuse mechanisch verbunden werden, beispielsweise durch einen Schnappverschluss oder mit Hilfe von Schrauben und Gewindebohrungen.

Die Materialauswahl ist weder für die inneren noch für die äusseren Komponenten der Fixiervorrichtung eingeschränkt. Sowohl metallische als auch auf Kunststoff basierende Komponenten sind einsetzbar.

Nachfolgend wird die Erfindung anhand von Zeichnungen näher erläutert. Dabei zeigt:
- Fig. 1: in Explosionsdarstellung eine erfindungsgemässe Fixiervorrichtung 1 in einer vorzugsweisen Ausgestaltung mit einer hohlzylindrischen inneren Fixiereinheit 11 und einer äusseren Fixiereinheit 12, die aus zwei schalenförmigen Vorrichtungsteilen 121, 122 besteht, welche mittels Schrauben 7 miteinander verbindbar sind;
- Fig. 1a: eine alternativ in die Fixiervorrichtung 1 von Fig. 1 einsetzbare innere Fixiereinheit 11, die sternförmig ausgestaltet und mit axial verlaufenden Zacken 116 versehen ist;
- Fig. 2: die Fixiervorrichtung 1 von Fig. 1 nach dem Einsetzen der inneren Fixiereinheit 11 und dem Zusammenfügen der beiden Vorrichtungsteile 121, 122 der äusseren Fixiereinheit 12, die formschlüssig ineinander greifende Verbindungselemente 1215; 1226 und 1216, 1225 aufweist;
- Fig. 3a: eine schematische Darstellung eines mehradrigen Kabels 9, an dessen Frontende ein Teil des Kabelmantels 91 entfernt wurde, um die Leitungsadern bzw. den Adernverbund 92 freizulegen;
- Fig. 3b: das Kabel 9 von Fig. 3a mit einem Längsschnitt 910 im Kabelmantel 91, welcher erlaubt, den Kabelmantel 91 frontseitig aufzuweiten;
- Fig. 3c: das Kabel 9 von Fig. 3b mit einer auf den freigelegten Adernverbund 92 aufgeschobenen inneren Fixiereinheit 11, die in Pfeilrichtung gegen den Kabelmantel 91 verschoben wird;
- Fig. 3d: das Kabel 9 von Fig. 3c mit der teilweise unter den aufgeweiteten Kabelmantel 91 eingeschoben inneren Fixiereinheit 11;
- Fig. 3e: das Kabel 9 von Fig. 3d mit der vollständig unter den aufgeweiteten Kabelmantel 91 eingeschoben inneren Fixiereinheit 11;
- Fig. 3f: das Kabel 9 von Fig. 3e mit dem vollständig unter den aufgeweiteten Kabelmantel 91 eingeschoben inneren Fixiereinheit 11 und einer zweiteiligen äusseren Fixiereinheit 12, welche die innere Fixiereinheit 11 und ein dazwischen liegendes Segment des Kabelmantels 91 umfasst;
- Fig. 4: eine in ein elektrisches Gerät 8 integrierte Fixiervorrichtung 1 mit einem zu fixierenden Kabel 9, an dessen Frontende der Kabelmantel 91 verkürzt ist und der Adernverbund 92 mit einer Abschirmung 93 hervortritt, welche von einer inneren Fixiereinheit 11 umschlossen ist, die eine Schlitzöffnung 113 und ein abgewinkeltes Kontaktelement 118 aufweist;
- Fig. 5: eine erfindungsgemässe Fixiervorrichtung 1 in einer weiteren vorzugsweisen Ausgestaltung mit einer ringförmigen inneren Fixiereinheit 11 und einer ringförmigen äusseren Fixiereinheit 12, die durch Rastelemente 114, 124 miteinander verbindbar sind;
- Fig. 6: die Fixiervorrichtung 1 von Fig. 5 mit einem durch die äussere Fixiereinheit 12 hindurch geführten Kabel 9, dessen Leitungsadern 92 und die Kabelabschirmung 93 durch die Durchtrittsöffnung 110 der inneren Fixiereinheit 11 hindurch geführt sind und dessen Kabelmantel 91 an der Aussenseite der inneren Fixiereinheit 11 anliegt; und
- Fig. 7: eine Schnittdarstellung der inneren und der äusseren Fixiereinheit 11, 12 entlang der in Fig. 6 eingezeichneten Schnittlinie sowie eine Detaildarstellung eines in der äusseren Fixiereinheit 12 vorgesehenen Rastkanals 1240.

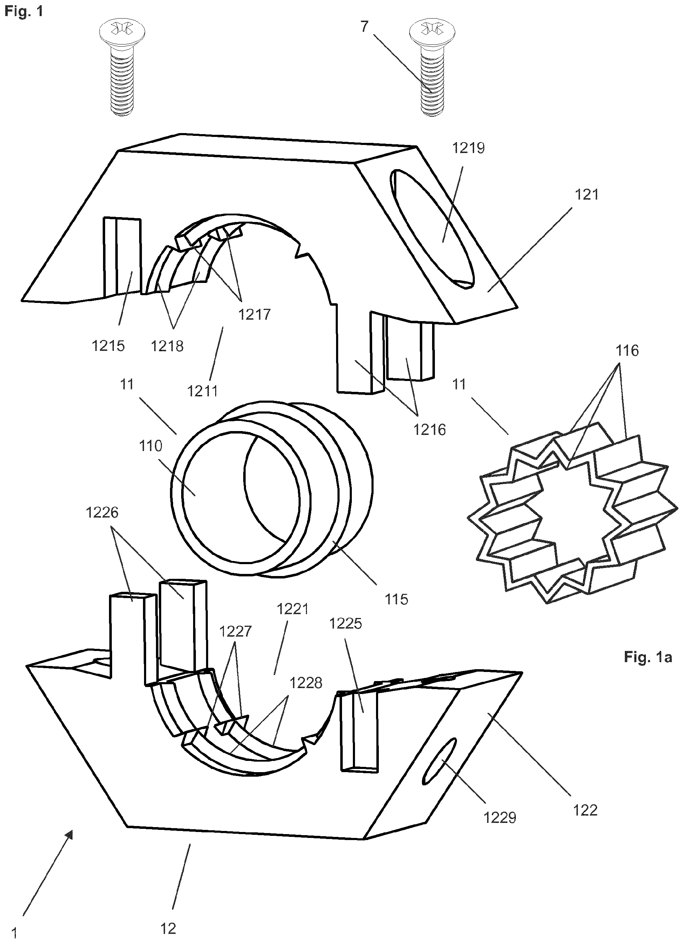

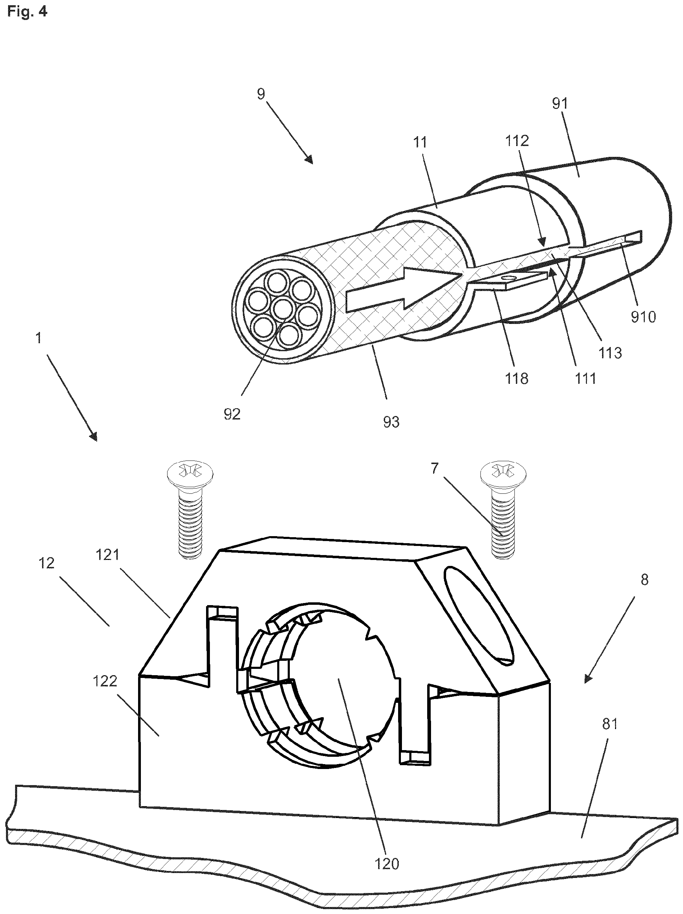

Fig. 1 zeigt in Explosionsdarstellung eine erfindungsgemässe Fixiervorrichtung 1, mittels der ein Kabel 9 (siehe Fig. 4) vorteilhaft fixiert und schonend gehalten werden kann, das eine oder mehrere Leitungsadern 92, gegebenenfalls eine metallene Abschirmung 93 und einen Kabelmantel 91 aufweist. Die Fixiervorrichtung 1 kann vorteilhaft innerhalb eines Steckverbinders oder am Eingang eines elektrischen Geräts 8, beispielsweise an einem Gehäuse oder Gehäuseboden 81 angeordnet sein. Vorzugsweise ist ein Teil der Fixiervorrichtung 1 ein integraler Bestandteil eines Geräts 8 oder eines Steckverbinders (siehe Fig. 4).

Die Fixiervorrichtung 1, die in Fig. 1 in einer vorzugsweisen Ausgestaltung gezeigt ist, umfasst eine hülsenförmig ausgebildete innere Fixiereinheit 11 mit einer Durchtrittsöffnung 110 sowie eine äussere Fixiereinheit 12 auf, die in dieser Ausgestaltung aus zwei Vorrichtungsteilen 121, 122 besteht. Die beiden Vorrichtungsteile 121, 122 sind schalenförmig ausgebildet und weisen kanalförmige Ausnehmungen 1211 bzw. 1221 auf, die nach dem Zusammenfügen der Vorrichtungsteile 121, 122 eine der Aufnahme des Kabels 9 und der inneren Fixiereinheit 11 dienende Durchtrittsöffnung 120 bilden (siehe Fig. 4).

Die Vorrichtungsteile 121, 122 sind durch Verbindungsschrauben 7 miteinander verbindbar, die je durch eine Montageöffnung 1219 im ersten Vorrichtungsteil 121 hindurch in eine Gewindebohrung 1229 im zweiten Vorrichtungsteil 122 geführt werden können. Die beiden Vorrichtungsteile 121, 122 können auch durch weitere Verbindungsvorrichtungen, wie Rastelemente, vorteilhaft miteinander verbunden werden.

Die äussere Fixiereinheit 12 kann auch einteilig ausgestaltet sein oder mehr als zwei Vorrichtungsteile 121, 122, ... aufweisen. Bei einer mehrteiligen Ausführung der äusseren Fixiereinheit 12 werden die Vorrichtungsteile 121, 122 vorzugsweise derart ausgestaltet, dass Teile davon formschlüssig in einander eingreifen können, so dass sie sich bei repetitiven Torsions- und/oder Biegebelastungen nicht gegeneinander verschieben können. Dies kann vorteilhaft durch die in Fig. 1 gezeigten Verbindungsstäbe 1226, 1216 und die dazu korrespondierenden Ausnehmungen 1225, 1215 erreicht werden.

Diese Verbindungsstäbe 1226, 1216 und Ausnehmungen 1225, 1215 können vorteilhaft auch mit zueinander korrespondierenden Rastelementen versehen werden. Beim Einschieben der Verbindungsstäbe 1226, 1216 in die Ausnehmungen 1225, 1215 resultieren in diesem Fall stabile Rastverbindungen, weshalb auf den Einsatz der Verbindungsschrauben 7 verzichtet werden kann.

In den kanalförmigen Ausnehmungen 1211, 1221 sind Formelemente 1217, 1218 bzw. 1227, 1228 vorgesehen, die in den Kabelmantel 91 des eingelegten Kabels 9 eingreifen können. Es ist gezeigt, dass ein Teil der Formelemente 1218, 1228 Ringe bilden, welche beabstandet voneinander von der Aussenseite in den Kabelmantel 91 eingreifen können, so dass im Kabelmantel 91 eine erste und eine zweite ringförmige Druckstelle erzeugt werden. Ebenso ist an der Aussenseite der inneren Fixiereinheit 11 ein ringförmiges Formelement 115 vorgesehen, welches von der Innenseite in den Kabelmantel 91 eingreifen und eine dritte ringförmige Druckstelle erzeugen kann, die zwischen der ersten und der zweiten ringförmigen Druckstelle liegt. Durch die resultierenden Einformungen und Druckstellen werden die äussere und innere Fixiereinheit 11, 12 unverschiebbar mit den Kabelmantel 91 und dem Kabel 9 verbunden.

Fig. 1a zeigt eine alternativ in die Fixiervorrichtung 1 von Fig. 1 einsetzbare Ringförmige innere Fixiereinheit 11, die sternförmig ausgestaltet und mit axial verlaufenden Kanten 116 versehen ist. Aufgrund des zackenförmigen Verlaufs der Hülse weisen die Kanten 116 nach aussen und nach innen. Nach aussen können die Kanten 116 in den Kabelmantel 91 eingreifen. Die nach innen weisenden Kanten 116 können in eine Kabelschicht eingreifen, welche den Adernverbund 92 umschliesst. Alternativ können Formelemente auch nur an der Innenwand oder Aussenwand der inneren Fixiereinheit 11 vorgesehen sein, während die gegenüberliegende Wand eine glatte Zylinderfläche bildet. Obwohl die exemplarisch gezeigte innere Fixiereinheit 11 einen Sternquerschnitt mit ausgeprägtem Zacken aufweist, werden vorzugsweise feiner strukturierte Formelemente 116 gewählt, durch die sichergestellt wird, dass eine feste Verbindung mit den Kabelschichten, insbesondere dem Kabelmantel 91, resultiert, ohne diese zu verletzen. Beispielsweise werden Strukturen mit Strukturelementen verwendet, deren Höhe beispielsweise im Bereich von 0,1mm - 0,5mm liegt.

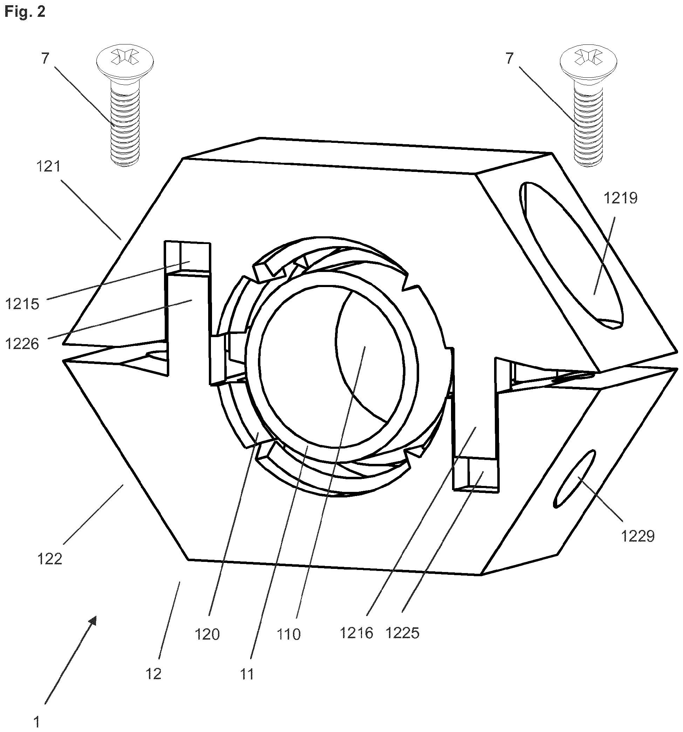

Fig. 2 zeigt die Fixiervorrichtung 1 von Fig. 1 nach dem Einsetzen der inneren Fixiereinheit 11 und dem Zusammenfügen der beiden Vorrichtungsteile 121, 122 der äusseren Fixiereinheit 12, wodurch die genannte Durchtrittsöffnung 120 gebildet wird, die der Aufnahme des Kabels 9 und der inneren Fixiereinheit 11 dient. Die Verbindungselemente 1215; 1226 und 1216, 1225 können nun formschlüssig ineinander eingreifen, gegebenenfalls ineinander einrasten, falls einander zugewandte Formelementen aufweisen, die in einander eingreifen können.

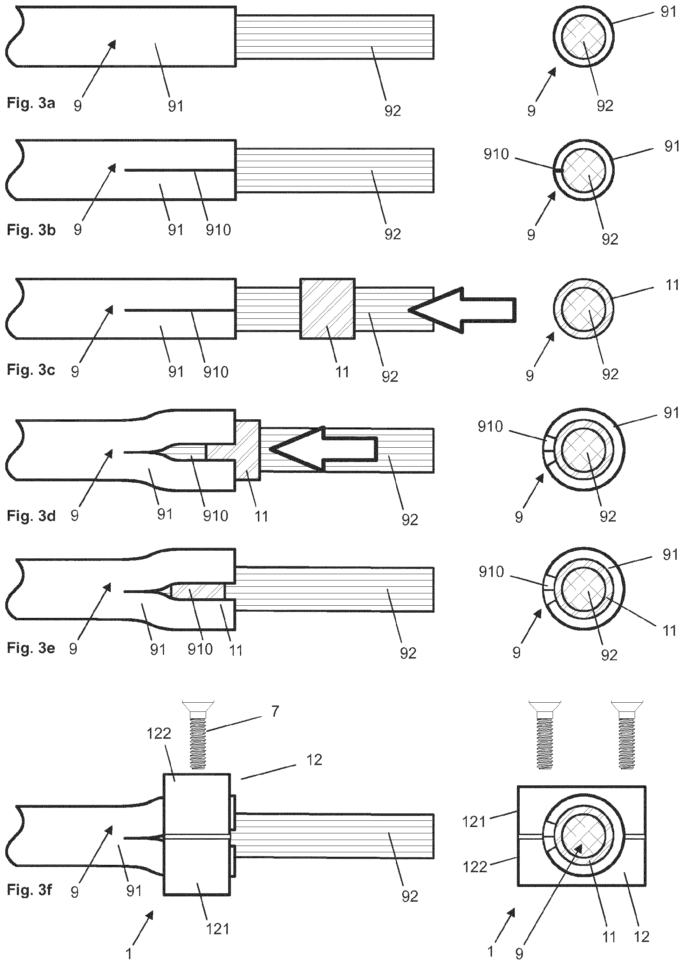

Die Figuren 3a bis 3f zeigen die Schritte zur Fixierung eines Kabels 9 mittels einer erfindungsgemässen Fixiervorrichtung 1, welche die beschriebenen Vorrichtungsteile 11, 12 aufweist. Links ist die Seitenansicht und rechts ist die Frontansicht des Kabels 9 gezeigt. Es ist zu beachten, dass lediglich eine schematische Darstellung vorliegt und die Dimensionen der Fixiervorrichtung 1 und der Fixiereinheiten 11, 12 unter Berücksichtigung der Abmessungen des Kabels 9 frei wählbar sind.

Fig. 3a zeigt schematisch ein mehradriges Kabel 9, dessen Kabelende abgemantelt wurde, so dass der Adernverbund oder ein Bündel von Kupferlitzen 92 freigelegt wurde.

Fig. 3b zeigt das Kabel 9 mit einem im Kabelmantel 91 vorgesehenen Einschnitt 910, der über eine Länge von vorzugsweise einigen Zentimetern parallel zur Kabelachse bis zum Ende des Kabelmantels 91 verläuft.

Fig. 3c zeigt schematisch eine innere Fixiereinheit 11, die über den Adernverbund 92 bis an den eingeschnittenen Kabelmantel 91 herangeführt wird.

Fig. 3d zeigt das Einschieben der inneren Fixiereinheit 11 unter den eingeschnittenen Kabelmantel 91, der entlang dem Einschnitt 910 leicht aufgeweitet wurde, um das Einschieben der inneren Fixiereinheit 11 zu erlauben.

Fig. 3e zeigt die innere Fixiereinheit 11 unter dem Kabelmantel 91 in der Endposition. Es ist auch möglich, die innere Fixiereinheit 11 nur partiell unter den Kabelmantel 91 einzuschieben oder deutlich weiter als in Fig. 3e gezeigt.

Fig. 3f zeigt das Kabel 9 mit der fertig montierten Fixiervorrichtung 1. In dieser vorzugsweisen Ausgestaltung wurde eine äussere Fixiereinheit 12 mit zwei Vorrichtungsteilen 121, 122 verwendet, die entweder mittels den gezeigten Verbindungsschrauben 7 oder den beschriebenen Rastelementen miteinander verbindbar sind. Nach der Montage der äusseren Fixiereinheit 12 ist der Kabelmantel 91 frontseitig zwischen der inneren und äusseren Fixiereinheit 11, 12 festgeklemmt. Vorzugsweise üben die äussere Fixiereinheit 12 und die innere Fixiereinheit 11 auch einen zumindest minimalen Druck auf den Adernverbund 92 aus, so dass sich dieser nicht oder nur bei grösserer Krafteinwirkung gegenüber der Fixiervorrichtung 1 verschieben kann. Auf diese Weise wird verhindert, dass der Kabelmantel 91 regelmässig bewegt wird und ermüden kann.

Fig. 4 zeigt in schematischer Darstellung das Frontende eines Kabels 9, welches einen Adernverbund 92 aufweist, der von einer metallischen Abschirmung 93 umschlossen ist. Auf die Abschirmung 93 ist eine aus Metall gefertigte innere Fixiereinheit 11 aufgesetzt, die einen Längsschlitz 113 und ein Kontaktelement 118 aufweist. Die an den Längsschlitz 113 angrenzenden Enden 111, 112 der inneren Fixiereinheit 11 sind voneinander beabstandet, weshalb die innere Fixiereinheit 11 zusammengefügt werden kann, bis die beiden Enden 111, 112 aufeinander treffen, die in vorzugsweisen Ausgestaltungen mit Flanschelementen versehen sind, die im gespannten Zustand der inneren Fixiereinheit 11 parallel aneinander liegen. Die elastische innere Fixiereinheit 11 kann daher in einem gewissen Mass komprimiert und gespannt werden, ohne dass ein zu hoher Druck auf den Adernverbund 92 ausgeübt wird. Auf diese Weise kann auch eine Anpassung an den Durchmesser des Adernverbunds 92 vorteilhaft vollzogen werden.

Ferner ist gezeigt, dass der Kabelmantel 91 frontseitig einen Längsschlitz 910 aufweist, welcher erlaubt, den Kabelmantel 91 frontseitig aufzuweiten, um die innere Fixiereinheit 11 in Pfeilrichtung einzuschieben (siehe Fig. 3d).

In dieser vorzugsweisen Ausgestaltung weist die innere Fixiereinheit 11 ferner ein radial nach aussen gerichtetes Flanschelement bzw. eine Kontaktplatte 118 auf, an die ein Erdungskabel anschliessbar ist. Die innere Fixiereinheit 11 dient daher zusätzlich der zuverlässigen elektrischen Kontaktierung der Abschirmung 93.

Fig. 4 zeigt unterhalb des Kabels 9 ferner eine äussere Fixiereinheit 12, die zwei nicht identische Vorrichtungsteile 121 und 122 umfasst. Das untere Vorrichtungsteil 122 ist auf dem Gehäuse 81 eines elektrischen oder elektronischen Geräts 8 angeordnet und gegebenenfalls einstückig mit diesem verbunden. Nach dem Anheben des oberen Vorrichtungsteils 121 kann das mit der inneren Fixiereinheit 11 bestückte Kabel 9 durch die Durchtrittsöffnung 120 hindurchgeführt werden. Anschliessend werden die beiden Vorrichtungsteile 121 und 122 der äusseren Fixiereinheit 12 z.B. mittels Schrauben 7 miteinander verbunden.

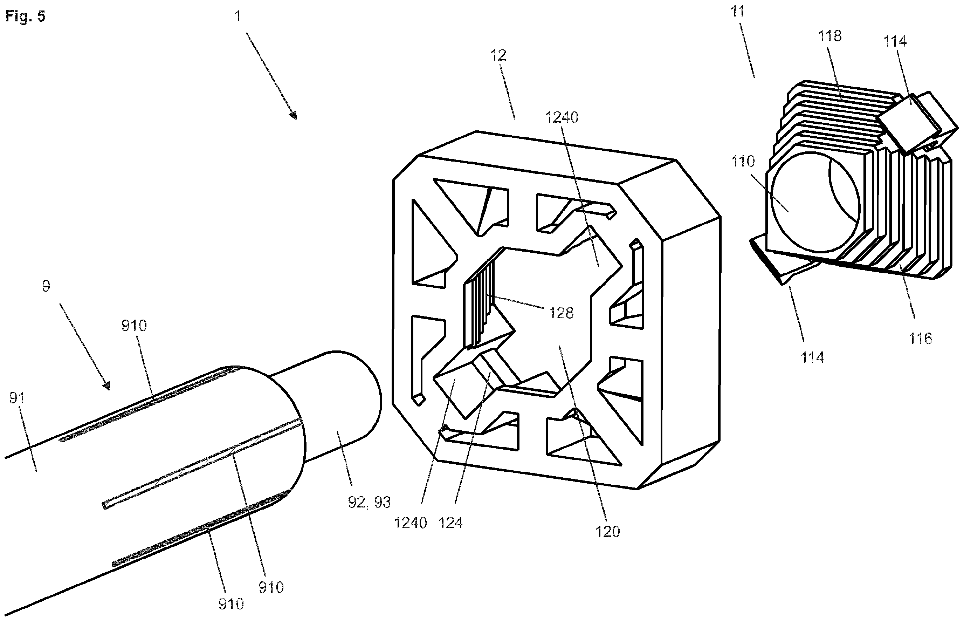

Fig. 5 zeigt eine erfindungsgemässe Fixiervorrichtung 1 in einer weiteren vorzugsweisen Ausgestaltung mit einer ringförmigen inneren Fixiereinheit 11 und einer ringförmigen äusseren Fixiereinheit 12, die ineinander verschiebbar und durch Rastelemente 114, 124 miteinander verbindbar sind.

Die Durchtrittsöffnung 120 der äusseren Fixiereinheit 12 ist auf einander gegenüberliegenden Seiten radial erweitert, wodurch zwei Rastkanäle 1240 gebildet werden, in denen je ein Rastelement 124 vorgesehen ist. Dazu korrespondierend ist die innere Fixiereinheit 11 auf einander gegenüberliegenden Seiten mit nach aussen ragenden Rastelementen 114 versehen, die in die Rastkanäle 1240 der äusseren Fixiereinheit 12 einführbar sind, bis die zueinander korrespondierenden Rastelemente 114 und 124 gegenseitig einrasten. Die elastisch gehaltenen Rastelemente 114 der inneren Fixiereinheit 11, die bügelförmig oder winkelförmig nach aussen ragen, sind nach der Verbindung der Fixiereinheiten 11 und 12 innerhalb der äusseren Fixiereinheit 12 versenkt und gut geschützt. Durch Einführen eines Schraubendrehers in die Rastkanäle 1240 können die Rastelemente 114, 124 wieder voneinander gelöst werden.

Die Durchtrittsöffnung 120 der äusseren Fixiereinheit 12 und die Aussenseite der inneren Fixiereinheit 11 sind mit zueinander korrespondierenden Treppenverläufen 118, 128 versehen. In der gezeigten Ausgestaltung ist die innere Fixiereinheit 11 pyramidenförmig ausgestaltet und formschlüssig in die Durchtrittsöffnung 120 der äusseren Fixiereinheit 12 einsetzbar. Die innere Fixiereinheit 11 kann daher nur so weit in die äussere Fixiereinheit 12 eingesetzt werden, bis die formschlüssige Verbindung vorliegt bzw. der Kabelmantel 91 festgeklemmt ist. In dieser Position liegt zusätzlich die Verbindung zwischen den Rastelementen 114, 124 vor, die verhindert, dass die innere Fixiereinheit 11 wieder zurückgezogen werden kann.

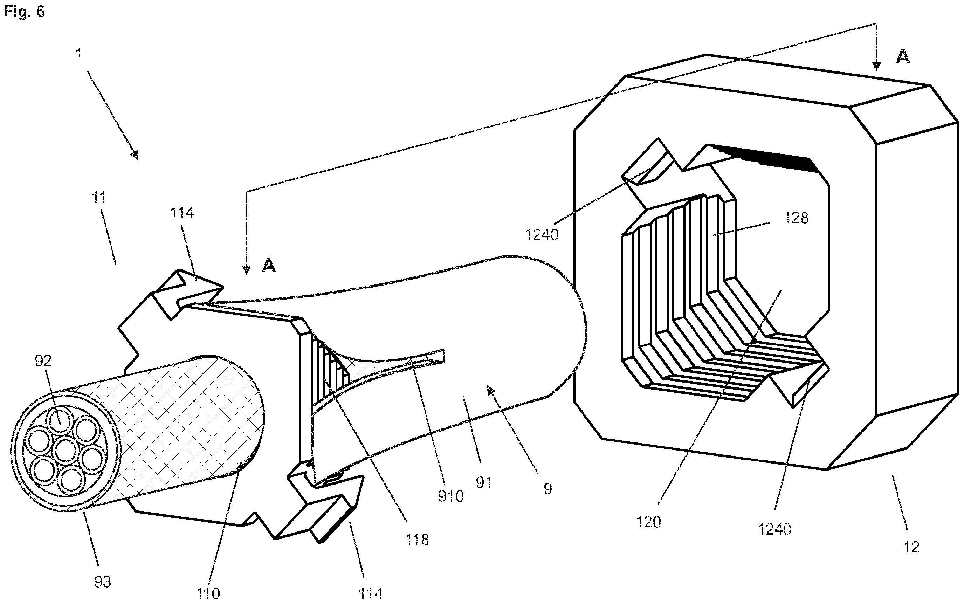

Nach der Durchführung des elektrischen Kabels 9 durch die äussere Fixiereinheit 12 und der Durchführung des Adernverbunds 92 und der Kabelabschirmung 93 durch die innere Fixiereinheit 11, wie dies in Fig. 6 gezeigt ist, liegt der mit mehreren Schlitzen 910 versehene Kabelmantel 91 zwischen dem Treppenverlauf 118 an der Aussenseite der inneren Fixiereinheit 11 und dem Treppenverlauf 128 in der Durchtrittsöffnung 120 der äusseren Fixiereinheit 12. Die Treppenformen 118, 128 greifen in den Kabelmantel 91 ein und halten diesen nach der Verbindung der Fixiereinheiten 11, 12 zuverlässig fest. Es erfolgt somit eine ideale Zugsentlastung durch den Kabelmantel 91, ohne den Adernverbund 92 oder die Abschirmung 93 zu belasten. Bei Ausübung einer Zugkraft auf das Kabel wird die innere Fixiereinheit 11 weiter gegen die äussere Fixiereinheit 12 gezogen, so dass die innere Fixiereinheit 11 stärker gegen den festgeklemmten Kabelmantel 91 gepresst wird. Besonders wesentlich ist, dass die einwirkende Zugkraft lediglich die beiden stabilen Fixiereinheiten 11, 12 zusammendrückt und nicht auf die Rastelemente 114, 124 einwirkt. Diese werden belastet, wenn das Kabel 9 gegen die Fixiervorrichtung 1, gegebenenfalls gegen einen Steckverbinder oder ein mit der Fixiervorrichtung 1 versehenes Gerät gedrückt wird. Diese Belastung ist jedoch minimal, weshalb die Fixiervorrichtung 1 einerseits hohen Zugkräften standhält und andererseits keinen kritischen Belastungen unterliegt.

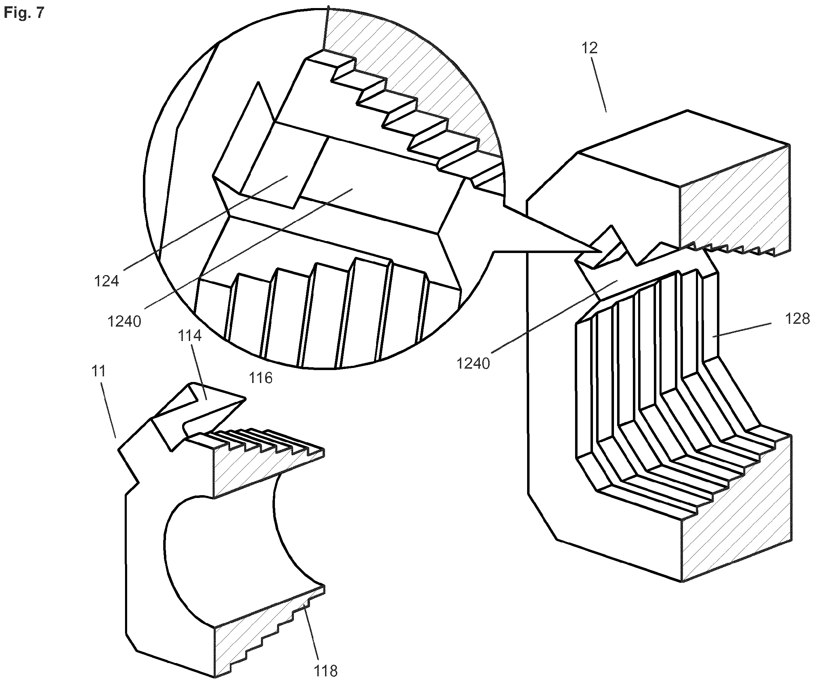

Fig. 7 zeigt eine Schnittdarstellung der inneren und der äusseren Fixiereinheit 11, 12 entlang der in Fig. 6 eingezeichneten Schnittlinie sowie eine Detaildarstellung eines der in der äusseren Fixiereinheit 12 vorgesehenen Rastkanäle 1240.

### Bezugszeichenliste

- 1: Fixiervorrichtung
- 11: innere Fixiereinheit
- 110: Durchtrittsöffnung in der inneren Fixiereinheit
- 111: erstes Ende der inneren Fixiereinheit 11
- 1221: kanalförmige Ausnehmung
- 112: zweites Ende der inneren Fixiereinheit 11
- 113: Schlitzöffnung in der inneren Fixiereinheit 11
- 114: Rastelemente, Rasthaken
- 115: ringförmiges Formelement
- 116: axial verlaufende Formelemente
- 118: Treppenverlauf an der inneren Fixiereinheit 11
- 12: äussere Fixiereinheit
- 120: Durchtrittsöffnung in der äusseren Fixiereinheit 12
- 121: erstes Teil der äusseren Fixiereinheit 12
- 1211: kanalförmige Ausnehmung
- 1215: Ausnehmung im ersten Vorrichtungsteil 121
- 1216: Verbindungsstab am ersten Vorrichtungsteil 121
- 1217: erstes Formelement am ersten Vorrichtungsteil 121
- 1218: zweites Formelement am ersten Vorrichtungsteil 121
- 1219: Montageöffnung im ersten Vorrichtungsteil 121
- 122: zweites Teil der äusseren Fixiereinheit 12
- 1221: kanalförmige Ausnehmung
- 1225: Ausnehmung im zweiten Vorrichtungsteil 122
- 1226: Verbindungsstab am zweiten Vorrichtungsteil 122
- 1227: erstes Formelement am zweiten Vorrichtungsteil 122
- 1228: zweites Formelement am zweiten Vorrichtungsteil 122
- 1229: Montageöffnung im zweiten Vorrichtungsteil 122
- 124: Rastelemente
- 1240: Rastkanal
- 128: Treppenverlauf an der äusseren Fixiereinheit 12
- 7: Verbindungsschrauben
- 8: elektrisches Gerät
- 81: Installationskörper oder Gehäuse des Geräts 8
- 9: elektrisches Kabel
- 91: Kabelmantel
- 910: Schlitz im Kabelmantel
- 92: Leitungsadern
- 93: Abschirmung

## Patentansprüche

1. Vorrichtung (1) zur Fixierung eines elektrischen Kabels (9) insbesondere im Bereich einer Kabeldurchführung (8), welches Kabel (9) eine oder mehrere Leitungsadern (92) und gegebenenfalls eine metallene Abschirmung (93) aufweist, die von einem Kabelmantel (91) umschlossen sind, mit einer äusseren Fixiereinheit (12), mittels der das Kabel (9) zumindest teilweise umschliessbar und ein Anpressdruck auf den Kabelmantel (91) ausübbar ist, mittels dessen das Kabel (9) fixierbar ist, und die eine Durchtrittsöffnung (120) aufweist, die der Durchführung des Kabels (9) und der Aufnahme einer inneren Fixiereinheit (11) dient, die derart ausgestaltet ist, dass sie zwischen dem Kabelmantel (91) und den Leitungsadern (92) einfügbar ist, so dass sie den von der äusseren Fixiereinheit (12) auf den Kabelmantel (91) ausgeübten Anpressdruck zumindest teilweise aufnehmen kann, **dadurch gekennzeichnet, dass** die äussere Fixiereinheit (12) und die innere Fixiereinheit (11) ringförmig ausgestaltet, ineinander verschiebbar und durch Rastelemente (114, 124) miteinander verbindbar sind und dass die Aussenseite der inneren Fixiereinheit (11) und die Durchtrittsöffnung (120) der äusseren Fixiereinheit (12) mit treppenförmigen Abstufungen (116, 126) versehen sind, die zueinander korrespondieren und dass die innere Fixiereinheit (11) pyramidenförmig ausgestaltet und formschlüssig in die dazu korrespondierende Durchtrittsöffnung (120) der äusseren Fixiereinheit (12) einsetzbar ist.

2. Vorrichtung (1) nach Anspruch 1, **dadurch gekennzeichnet, dass** die äussere Fixiereinheit (12) Teil eines Steckverbinders, eines Steckers oder einer Kupplung, und vorzugsweise mittels einer Überwurfmutter komprimierbar ist.

3. Vorrichtung (1) nach Anspruch 1 oder 2, **dadurch gekennzeichnet,**
a) **dass** die äussere Fixiereinheit (12) ringförmig ausgestaltet ist, oder
b) **dass** die äussere Fixiereinheit (12) aus zwei vorzugsweise schalenförmigen Vorrichtungsteilen (121, 122) besteht, die formschlüssig ineinander eingreifende Vorrichtungselemente (1215, 1226; 1216, 1225) aufweisen.

4. Vorrichtung (1) nach Anspruch 3, **dadurch gekennzeichnet, dass** die zwei Vorrichtungsteile (121, 122) mittels Verbindungselementen (7), wie Schrauben oder Gewindeelementen und/oder einem Scharnier, miteinander verbunden und gegeneinander führbar sind.

5. Vorrichtung (1) nach einem der Ansprüche 1 - 4, **dadurch gekennzeichnet,**
a) **dass** die innere Fixiereinheit (11) eine in sich geschlossene elastische oder nicht-elastische Hülse bildet; oder
b) **dass** die innere Fixiereinheit (11) eine nicht in sich geschlossene, elastische Hülse mit voneinander beabstandeten oder sich überlappenden Hülsenenden (111, 112) bildet, die gegebenenfalls eine Schlitzöffnung (113) begrenzen; und/oder
c) **dass** die innere Fixiereinheit (11) der Kontaktierung einer Metallschicht des elektrischen Kabels (9) dient und ein Kontaktelement (118) aufweist.

6. Vorrichtung (1) nach einem der Ansprüche 1 - 5, **dadurch gekennzeichnet, dass** die innere Fixiereinheit (11) auf der Innenseite und/oder der Aussenseite eine glatte Oberfläche aufweist oder mit Formelementen, wie Kanten, Rillen, Abstufungen, Rippen, Einfaltungen oder Zacken versehen ist, die vorzugsweise achsparallel zur Längsachse der inneren Fixiereinheit (11) verlaufen.

7. Vorrichtung (1) nach Anspruch 1, **dadurch gekennzeichnet, dass** die innere Fixiereinheit (11) wenigstens zwei nach aussen ragende erste Rastelemente (114) aufweist und dass die äussere Fixiereinheit (12) wenigstens zwei parallel zur Durchtrittsöffnung (120) verlaufende Rastkanäle (1240) mit wenigstens einem darin vorgesehenen Rastelement (124) aufweist.

8. Vorrichtung (1) nach einem der Ansprüche 1 - 7, **dadurch gekennzeichnet, dass** die innere Fixiereinheit (11) wenigstens ein nach aussen dem Kabelmantel (91) zugewandtes Formelement (115) aufweist und/oder dass die äussere Fixiereinheit (12) wenigstens ein dem Kabel (9) zugewandtes Formelement (1217, 1218; 1227, 1228) aufweist, welches Material des Kabelmantels (91) verdrängen oder aufnehmen kann.

9. Vorrichtung (1) nach Anspruch 8, **dadurch gekennzeichnet, dass** das Formelement (115) der inneren Fixiereinheit (11) eine Ausnehmung, wie eine umlaufende Rille, ist, die von der äusseren Fixiereinheit (12) verdrängtes Material des Kabelmantels (9) aufnehmen kann; oder dass das Formelement (115) der inneren Fixiereinheit (11) eine Erweiterung, wie eine umlaufende Rippe ist, die Material des Kabelmantels (91) in das entsprechende Formelement (1217, 1218; 1227, 1228) der äusseren Fixiereinheit (12) verdrängen kann.

10. Vorrichtung (1) nach einem der Ansprüche 3 - 9, **dadurch gekennzeichnet, dass** die äussere Fixiereinheit (12) bzw. das erste und/oder das zweite Vorrichtungsteil (121, 122) der äusseren Fixiereinheit (12) mit einem Installationskörper (81), insbesondere einem Gehäuse, eines elektrischen Geräts oder eines Steckverbinders verbunden oder verbindbar ist.

11. Vorrichtung (1) nach einem der Ansprüche 1 - 10, **dadurch gekennzeichnet, dass** die äussere Fixiereinheit (12) aus Metall oder Kunststoff gefertigt ist und dass die innere Fixiereinheit (11) aus Metall oder Kunststoff gefertigt ist.

12. Vorrichtung (1) nach einem der Ansprüche 1 - 11 mit dem fixierten Kabel (9), dessen Kabelmantel (91) die Leitungsadern (92), gegebenenfalls eine metallene Abschirmung (93), sowie die innere Fixiereinheit (11) zumindest teilweise umschliesst und dessen Kabelmantel (91) von der äusseren Fixiereinheit (12) zumindest teilweise derart umschlossen ist, dass der Kabelmantel (91) zwischen der äusseren Fixiereinheit (12) und der inneren Fixiereinheit (11) gehalten ist.

## Claims

1. Device (1) for fixing an electrical cable (9), in particular in the region of a cable bushing (8), which cable (9) has one or more cable cores (92) and optionally a metal shield (93) which is covered by a cable sheath (91) are enclosed, with an outer fixing unit (12) by means of which the cable (9) at least partially embracing and a contact pressure on the cable sheath (91) is exercised, by means of which the cable (9) is fixable, and which has a passage opening (120) which serves to pass through the cable (9) and to receive a sleeve-shaped inner fixing unit (11) which is designed so as to be insertable between the cable sheath (91) and the conductor cores (92) in that it can at least partly accommodate the contact pressure exerted by the outer fixing unit (12) on the cable sheath (91) **characterized in that** the outer fixing unit (12) and the inner fixing unit (11) are annular, interengageable and connectable by latching elements (114, 124) and that the outer side of the inner fixing unit (11) and the passage opening (120) of the outer fixing unit (12) are provided with stepped steps (116, 126) which correspond to each other and **in that** the inner fixing unit (11) preferably designed pyramid-shaped and form-fitting manner in the corresponding passage opening (120) of the outer fixing unit (12) can be inserted.

2. Device (1) according to claim 1, **characterized in that** the outer fixing unit (12) is part of a connector, a plug or a coupling, and is preferably compressible by means of a union nut.

3. Device (1) according to claim 1 or 2, **characterized in that,**
a) that the outer fixing unit (12) is designed annular, or
b) that the outer fixing unit (12) consists of two preferably cup-shaped device parts (121, 122), the form-fitting intermeshing Device elements (1215, 1226, 1216, 1225).

4. Device (1) according to claim 3, **characterized in that** the two device parts (121, 122) are connected to one another and can be guided by means of connecting elements (7), such as screws or threaded elements and / or a hinge.

5. Device (1) according to one of the claims 1 - 4, **characterized in that,**
a) the inner fixing unit (11) forms a self-contained elastic or non-elastic sleeve; or
b) the inner fixing unit (11) forms a non-self-contained elastic sleeve having spaced apart or overlapping sleeve ends (111, 112) which optionally define a slot opening (113); and / or
c) the inner fixing unit (11) serves to contact a metal layer of the electric cable (9) and has a contact element (118).

6. Device (1) according to one of the claims 1 - 5, **characterized in that** the inner fixing unit (11) on the inside and / or the outside has a smooth surface or provided with form elements such as edges, grooves, gradations, ribs, folds or serrations, which are preferably axially parallel to the longitudinal axis of the inner fixing unit (11).

7. Device (1) according to claim 1, **characterized in that** the inner fixing unit (11) has at least two outwardly projecting first locking elements (114) and that the outer fixing unit (12) at least two parallel to the passage opening (120) extending latching channels (1240) has at least one latching element (124) provided therein.

8. Device (1) according to one of the claims 1 - 7, **characterized in that** the inner fixing unit (11) has at least one outwardly forming element (115) facing the cable sheath (91) and / or that the outer fixing unit (12) at least one of the cable (9) facing the mold element (1217, 1218, 1227, 1228) which can displace or receive material of the cable sheath (91).

9. Device (1) according to claim 8, **characterized in that** the molding element (115) of the inner fixing unit (11) is a recess, such as a circumferential groove, capable of receiving material displaced from the outer fixing unit (12) of the cable sheath (9); or that the molding element (115) of the inner fixing unit (11) is an extension, such as a circumferential rib, which can displace the material of the cable jacket (91) into the corresponding molding element (1217, 1218; 1227, 1228) of the outer fixing unit (12).

10. Device (1) according to one of the claims 3 - 9, **characterized in that** the outer fixing unit (12) or the first and / or the second device part (121, 122) of the outer fixing unit (12) with an installation body (81), in particular a housing, an electrical device or a connector is connected or connectable.

11. Device (1) according to one of the claims 1 - 10, **characterized in that** the outer fixing unit (12) is made of metal or plastic and that the inner fixing unit (11) is made of metal or plastic.

12. Device (1) according to one of the claims 1 - 11 with the fixed cable (9), whose cable sheath (91) at least partially surrounds the line cores (92), optionally a metal shield (93), and the inner fixing unit (11) and the cable sheath (91) of the outer fixing unit (12) is at least partially enclosed such that the cable sheath (91) between the outer fixing unit (12) and the inner fixing unit (11) is held.

## Revendications

1. Dispositif (1) pour la fixation d'un câble électrique (9), en particulier dans la zone d'une douille (8), lequel câble (9) ayant une ou plusieurs âmes de câble (92) et éventuellement un blindage métallique (93) par une gaine de câble (91) sont enfermées, avec un organe de fixation externe (12) au moyen du câble (9) au moins en partie être fermé et une pression de contact sur la gaine de câble (91) peut être exercée au moyen de laquelle le câble est fixe (9), ladite unité de fixation extérieure (12) présente une ouverture de passage (120) servant à la mise en oeuvre du câble (9) et le logement d'une unité de fixation intérieure en forme de manchon (11) qui est conçue de telle sorte qu'elle (91) et les fils conducteurs (92) peut être insérée entre la gaine de câble peut absorber, de sorte que l'extérieur de l'unité de fixation (12) sur la gaine du câble exercée (91) de pression au moins partiellement **caractérisé en ce que** l'unité de fixation extérieure (12) et l'unité de fixation intérieure (11) disposés annulairement, et un dans l'autre par des éléments d'encliquetage (114, 124) sont reliées les unes aux autres et que le côté extérieur de l'unité de fixation intérieure (11) et l'ouverture de passage (120) de l'unité de fixation extérieure (12) avec des marches en forme de marche (116, 126) sont prévus, correspondant à l'autre et que le unité de fixation interne (11) est de préférence en forme de pyramide et d'une manière à ajustement de forme dans l'ouverture de passage qui lui correspond (120) de l'unité de fixation extérieure (12) peut être utilisé.

2. Dispositif (1) selon la revendication 1, **caractérisé en ce que** l'unité de fixation extérieure (12) fait partie d'un connecteur, un bouchon ou un couplage, et est compressible, de préférence au moyen d'un écrou-raccord.

3. Dispositif (1) selon la revendication 1 ou 2, **caractérisé en ce que**
a) l'unité de fixation extérieure (12) est de configuration annulaire, ou
b) l'unité de fixation extérieure (12) se compose de deux parties de préférence en forme de cuvette du dispositif (121, 122) qui forme par verrouillage mutuel des éléments de dispositif (1215, 1226, 1216, 1225) ont.

4. Dispositif (1) selon la revendication 3, **caractérisé en ce que** les deux parties de dispositif (121, 122) au moyen d'éléments de liaison (7), tels que des vis ou des éléments filetés et / ou une charnière, reliés les uns aux autres et sont mutuellement réalisable.

5. Dispositif (1) selon une des revendications 1-4, **caractérisé en ce que**
a) l'unité de fixation intérieure (11) forme un manchon élastique ou non élastique fermé dans celui-ci; ou
b) l'unité de fixation intérieure (11) espacée d'une non autonome, le manchon élastique les uns avec les autres ou se chevauchant les extrémités de manchon (111, 112 formes), définir éventuellement une ouverture de fente (113); et / ou
c) l'unité de fixation interne (11) est utilisé pour la mise en contact d'une couche métallique du câble électrique (9) et un élément de contact (118).

6. Dispositif (1) selon une des revendications 1 - 5, **caractérisé en ce que** l'unité de fixation interne (11) à l'intérieur et / ou a l'extérieur d'une surface lisse ou est pourvue d'éléments de moule, tels que des bords, des rainures, des gradations, des nervures, des goussets ou des dents est, de préférence, qui étendent axialement parallèlement à l'axe longitudinal de l'unité de fixation interne (11).

7. Dispositif (1) selon la revendication 1, **caractérisé en ce que** l'unité de fixation interne (11) a deux faisant saillie vers l'extérieur des premiers éléments de verrouillage (114) comprend au moins et **en ce que** l'unité de fixation extérieure (12) au moins deux parallèlement à l'ouverture de passage (120) se prolongeant les canaux de verrouillage (1240) avec ayant au moins un élément de verrouillage prévu dans celui-ci (124).

8. Dispositif (1) selon une des revendications 1 - 7, **caractérisé en ce que** l'unité de fixation intérieure (11) faisant face à au moins une vers l'extérieur l'élément de gaine de câble (91) de formage (115) et / ou que l'unité de fixation extérieure (12) au moins un câble (9) faisant face à l'élément de moule (1217, 1218, 1227, 1228) qui déplacent ce que la matière de la gaine de câble (91) ou peut absorber.

9. Dispositif (1) selon la revendication 8, **caractérisé en ce que** l'élément de formage (115) de l'unité de fixation intérieure (11) présente un évidement, comme une rainure circonférentielle, qui peut loger l'unité de fixation extérieure (12) matériau déplacé de la gaine de câble (9); ou que l'élément de forme (115) de l'unité de fixation interne (11) une extension, par exemple une nervure circonférentielle, le matériau de la gaine de câble (91) dans l'élément de moule correspondant (1217, 1218, 1227, 1228) de l'unité de fixation externe peut déplacer (12),

10. Dispositif (1) selon une des revendications 3 - 9, **caractérisé en ce que** l'unité de fixation extérieure (12) ou le premier et / ou le second dispositif (121, 122) de l'unité de fixation extérieure (12) avec un corps de montage (81), en particulier est reliée à un boîtier d'un appareil électrique ou un connecteur ou peut être relié.

11. Dispositif (1) selon une des revendications 1 - 10, **caractérisé en ce que** l'unité de fixation extérieure (12) est réalisé en métal ou en matière plastique et **en ce que** l'unité de fixation interne (11) est réalisé en métal ou en plastique.

12. Dispositif (1) selon une des revendications 1 - 11 avec le câble fixe (9), dont la gaine de câble (91) enferme les conducteurs (92), éventuellement un blindage métallique (93) et l'unité de fixation interne (11) au moins partiellement et la gaine de câble (91) de l'unité extérieure de fixation (12) est au moins partiellement enfermé de manière à ce que la gaine de câble (91) entre l'unité de fixation extérieure (12) et l'unité de fixation interne (11) est maintenu.
